# EUROPÄISCHE PATENTSCHRIFT

(11) **EP 1 074 053 B1**
(45) Veröffentlichungstag und Bekanntmachung des Hinweises auf die Patenterteilung: **26.07.2006**
(21) Anmeldenummer: 98907885.2
(22) Anmeldetag: 06.02.1998
(51) Int. Cl.: H01L 35/08, H01L 35/10, H01L 35/32

(54) **THERMOELEMENT ZUR GEWINNUNG ELEKTRISCHER ENERGIE**
THERMOELEMENT FOR OBTAINING ELECTRIC ENERGY
THERMOELEMENT SERVANT A OBTENIR DE L'ENERGIE ELECTRIQUE

(43) Veröffentlichungstag der Anmeldung: 07.02.2001
(73) Patentinhaber: Seibold, Hans K., 78234 Engen (DE)
(72) Erfinder: Seibold, Hans K., 78234 Engen (DE)
(74) Vertreter: Späth, Dieter
(86) Internationale Anmeldenummer: PCT/DE1998/000329
(87) Internationale Veröffentlichungsnummer: WO 1998/035392

(56) Entgegenhaltungen:
- DE-A- 4 336 354
- GB-A- 2 090 418
- US-A- 4 098 617
- KINARD J R ET AL: "PERFORMANCE OF MULTILAYER THIN-FILM MULTIJUNCTION THERMAL CONVERTERS" IEEE TRANSACTIONS ON INSTRUMENTATION AND MEASUREMENT, Bd. 44, Nr. 2, 1.April 1995, Seiten 383-386, XP000539714

## Beschreibung

Die vorliegende Erfindung betrifft eine Thermoelement zur Gewinnung elektrischer Energie mit den Merkmalen des Oberbegriffs des Anspruchs 1.

Derartige Thermoelemente sind an sich bekannt. Die bekannten Thermoelemente weisen zwei verschiedene thermoelektrische Materialien auf, die an einer Kontaktstelle oder in einem Kontaktbereich elektrisch leitend miteinander verbunden sind. Eine erhöhte Temperatur im Kontaktbereich bewirkt aufgrund des sog. thermoelektrischen Effektes eine elektrische Spannung (Thermospannung) zwischen den beiden thermoelektrischen Materialien, bei geschlossenem Stromkreis fließt ein elektrischer Strom. Die Thermospannung ist temperaturabhängig und abhängig von den beiden thermoelektrischen Materialien (Seebeck-Effekt).

Dem Seebeck-Effekt wirkt die elektrische Leitfähigkeit der beiden thermoelektrischen Materialien entgegen, d. h. thermoelektrische Materialen mit hohem elektrischen Widerstand (schlechte Leiter) weisen einen großen Seebeck-Effekt auf, d. h. die Thermospannung ist hoch, wogegen bei thermoelektrischen Materialien mit geringem elektrischen Widerstand (Leiter) der Seebeck-Effekt gering, d. h. die Thermospannung niedrig ist.

Daraus ergibt sich ein Optimum und eine maximale Effektivität bekannter Thermoelemente, wenn deren beide thermoelektrische Materialien Halbleiter sind. Die Halbleiter sind durch eine freie Ladungsträgerkonzentration von 10¹⁸ bis 10²⁰ 1/cm³ charakterisiert.

Der Erfindung liegt die Aufgabe zugrunde, ein Thermoelement mit höherem Wirkungsgrad vorzuschlagen.

Diese Aufgabe wird erfindungsgemäß durch die Merkmale des Anspruchs 1 gelöst. Beim erfindungsgemäßen Thermoelement setzen sich die beiden thermoelektrischen Materialien außerhalb des Kontaktbereichs als elektrisch voneinander isolierte Schenkel fort. Diese Schenkel sind zumindest über einen Teil ihrer Länge ebenso wie der Kontaktbereich einer erhöhten Temperatur (Heißbereich) ausgesetzt und setzen sich bis in einen Bereich niedriger Temperatur (Kaltbereich) fort. Die beiden Schenkel bilden eine Art Anschlußleitungen des Kontaktbereichs. Die beiden thermoelektrischen Materialien weisen je einen eigenen elektrisch gut leitenden Leiter auf, der zumindest teilweise im Kontaktbereich ausgebildet ist, sich zu den Schenkeln fortsetzt und im wesentichen über die gesamte Länge der Schenkel erstreckt. Die Leiter sind, vorzugsweise über ihre gesamte Länge elektrisch leitend mit dem jeweiligen thermoelektrischen Material verbunden, stehen jedoch an keiner Stelle des Thermoelements in Kontakt miteinander. Auch im Kontaktbereich sind die beiden Leiter durch die zwischen ihnen angeordneten thermoelektrischen Materialien voneinander getrennt. Die vorliegende Erfindung ist grundsätzlich bei bekannten Thermoelementen anwendbar.

Durch die Erfindung wird die elektrische Leitfähigkeit der thermoelektrischen Materialien erhöht und dadurch der Wirkungsgrad des Thermoelementes verbessert. Es lassen sich thermoelektrische Materialien mit großem Seebeck-Effekt kombinieren mit guter Leitfähigkeit, was die Energieumwandlung vergrößert. Darüber hinaus ermöglicht die Erfindung neue Materialkombinationen, die bisher aufgrund ihrer schlechten elektrischen Leitfähigkeit nicht für Thermoelemente verwendbar waren. Als thermoelektrische Materialien kommen sowohl elektrische Leiter, als auch P- und N-leitendende Halbleiter als auch Nichtleiter/elektrische Widerstände in Betracht, wobei gute Wirkungsgrade bei Verwendung von Nichtleitern/elektrischen Widerständen und P- und N-leitenden Halbleitern zu erwarten sind. Bei den verwendeten thermoelektrische Materialien interessiert an sich nur deren Seebeck-Effekt. Außerdem sind vollkommen neue Konstruktionen von Thermoelementen möglich. So ermöglicht die Erfindung infolge des reduzierten Innenwiderstandes beispielsweise die Hintereinanderschaltung von vielen einzelnen Thermoelementen.

Hinzu tritt ein Synergie-Effekt, das erfindungsgemäße Thermoelement bildet zugleich ein Fotoelement, das seine thermoelektrischen Materialien treffende elektromagnetische Strahlung wie beispielsweise Licht in elektrische Energie wandelt. Dazu dürfen die thermoelektrischen Materialien nicht vollständig von ihren elektrischen Leitern abgedeckt oder die Leiter müssen transparent beispielsweise in Form einer dünn aufgedampften Silber- oder Goldschicht ausgebildet sein. Der Seebeck-Effekt wird beim erfindungsgemäßen Thermoelement durch einen Fotoeffekt ergänzt. Insbesondere läßt sich die Erfindung auf sog. Heiß-Kalt-Stromelemente, also auf Thermoelemente mit langen Schenkeln, anwenden. Die langen Schenkel sind notwendig, um den Heißbereich örtlich ausreichend weit vom Kaltbereich trennen zu können, um eine hohe thermische Isolierung des Heißbereichs vom Kaltbereich verwirklichen zu können, die für eine große Temperaturdifferenz erforderlich ist. Durch die erfindungsgemäßen Leiter (Finger) ist die Länge der Schenkel der thermoelektrischen Materialien unproblematisch. Im Gegenteil wird durch die Verlängerung der Schenkel die elektrische Energiegewinnung beim erfindungsgemäßen Thermoelement verbessert. Eine gute Energiewandlung ist zu erwarten, wenn eine dem Heißbereich ausgesetzte Länge oder Fläche des Thermoelements ungefähr ebenso lang bzw. groß wie eine Länge oder Fläche der Schenkel des Thermoelements im Kaltbereich ist. Die dem Heißbereich ausgesetzte Länge oder Fläche des Thermoelements umfaßt den Kontaktbereich einschließlich der Schenkel, soweit diese dem Heißbereich ausgesetzt sind. Ebenfalls läßt sich das erfindungsgemäße Thermoelement als Seebeck-Kühlelement ausbilden und verwenden.

Die Leiter des erfindungsgemäßen Thermoelements sind vorzugsweise thermisch neutral, d. h. sie weisen keinen Thermoeffekt mit dem jeweiligen thermoelektrischen Material auf. Die Leiter lassen sich beispielsweise als Leiterbahnen (Finger) auf Halbleiterbahnen aufbringen, die die thermoelektrische Materialen bilden. Die Halbleiterbahnen können ihrerseits auf einen Träger (Wafer) aufgebracht sein. Als Leiter eignen sich beispielsweise Silberlegierungen.

Zur Steigerung der Effektivität ist bei einer Ausgestaltung der Erfindung die Kontaktfläche groß ausgebildet, sie nimmt insbesondere den Heißbereich des Thermoelementes vollständig oder nahezu vollständig ein.

Eine Ausgestaltung der Erfindung weist zwei Drahtbündel auf, wobei verdrillte oder unverdrillte Einzeldrähte des einen Drahtbündels aus dem einen thermoelektrischen Material und die Einzeldrähte des anderen Drahtbündels aus dem anderen thermoelektrischen Material bestehen. In jedem Drahtbündel liegt ein elektrischer Leiter als zusätzlicher Einzeldraht (Seele) ein. Zur Ausbildung des Kontaktbereichs werden zwei Enden der beiden Drahtbündel an ihrem Umfang miteinander in Kontakt gebracht, wobei die einliegenden elektrischen Leiter voneinander getrennt bleiben. Die elektrischen Anschlüsse im Kaltbereich des Thermoelements werden an den beiden anderen Enden der beiden Drahtbündel beispielsweise durch Tauchlötung hergestellt, wodurch auf einfache Weise eine elektrisch leitende Verbindung mit den in den Drahtbündein einliegenden elektrischen Leitern hergestellt ist.

Im Kontaktbereich können die beiden thermoelektrischen Materialien z. B. durch Punktschweißung, Walzen oder im Falle von Halbleitern durch Diffusionstechnik kontaktiert sein, wobei die Leiter der thermoelektrischen Materialien keinesfalls in Kontakt miteinander gelangen dürfen.

Um eine gute thermische Isolierung zu erreichen, können bei einer Ausgestaltung der Erfindung die thermoelektrischen Materialien beider Schenkel in einem Übergangsbereich vom Heißbereich zum Kaltbereich unterbrochen und die Leiter für beide Schenkel getrennt elektrisch leitend verbunden sein. Die den Übergangsbereich überbrückende, elektrisch leitende Verbindung kann mittels zusätlicher Leiter oder durch durchgehend ausgebildete Leiter der thermoelektrischen Materialien bewerkstelligt sein.

Die Wirksamkeit des erfindungsgemäßen Thermoelementes wurde in nachfolgend geschildertem Versuch ermittelt. Verglichen werden drei Thermoelemente mit einem P- und einem N-leitenden Halbleiter aus dotiertem Silizium als thermoelektrischen Materialien. Die Schenkel weisen einen Querschnitt von 1 mm x 8 mm auf und sind im Heiß- und im Kaltbereich jeweils 8 cm lang. Eine dazwischenliegende lsolations- und Befestigungsfläche ist 4 cm dick. Im Heißbereich sind die Schenkel der Thermoelemente 1 und 2 an ihren Enden mit einer Klammer kontaktiert, auf der restlichen Länge voneinander isoliert. Bei Thermoelement 2 sind beide Schenkel an der außenliegenden Oberfläche auf ihrer gesamten Länge mit einer Silber-Sputterschicht versehen. Bei Thermoelement 3 ist die Kontaktfläche auf nahezu den gesamten Heißbereich ausgedehnt. Die Thermoelemente sind im Heißbereich in einem regelbaren Heißluftofen angebracht und durch isolierte Schlitze nach außen geführt. Jedem Thermoelement ist ein Lastwiderstand vorgeschaltet, der dem Innenwiderstand des Thermoelements entspricht.

| **delta T** | **Elem. 1** | | **Elem. 2** | | **Elem. 3** | |
|---|---|---|---|---|---|---|
| **Grad C** | **mV** | **mA** | **mV** | **mA** | **mV** | **mA** |
| **20** | **0,2** | **0,02** | **1,8** | **0,11** | **5,6** | **0,46** |
| **50** | **1,2** | **0,1** | **7,8** | **0,72** | **25,8** | **2,4** |
| **130** | **6,2** | **0,56** | **19,2** | **1,72** | **64,2** | **5,9** |
| **200** | **8,8** | **0,72** | **25,6** | **2,36** | **70,4** | **7,22** |
| **500** | **53,2** | **4,06** | **61,4** | **5,64** | **222,2** | **20,48** |
| **700** | **81,4** | **7,42** | **190,4** | **17,44** | **183,6** | **16,48** |

Die Erfindung wird nachfolgend anhand in der Zeichnung dargestellter Ausführungsbeispiele näher erläutert, die Ausführungsformen erfindungsgemäßer Thermoelemente in schematisierter, nicht maßstabsgetreuer Darstellung zeigen.

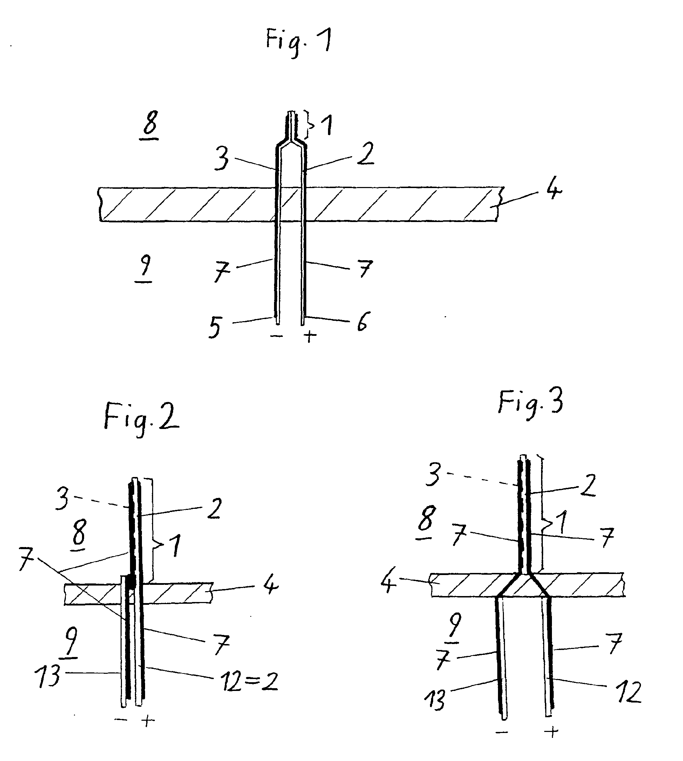

Figur 1 zeigt ein Thermoelement mit zwei Abstand voneinander aufweisenden Schenkeln 2, 3, die an einem Ende zu einem Kontaktbereich 1 miteinander verbunden sind. Die Schenkel 2, 3 bestehen aus einem P-leitenden und aus einem N-leitenden Halbleiter mit rechteckigem Querschnitt. Auf einander abgewandten Außenseiten der Halbleiter 2, 3 ist durch Sputtern ein Leiter 7 in Form einer dünnen Leiterbahn aus einer Silberlegierung aufgebracht. Dem Kontaktbereich 1 ferne Enden der Halbleiter 2, 3 bilden Stromabnahmestellen 5, 6. Die beiden Leiterbahnen 7 auf den einander abgewandten Außenseiten der Halbleiter 2, 3 sind vom Kontaktbereich 1, den sie im wesentlichen vollflächig bedecken, durchgehend bis zu den Stromabnahmestellen 5, 6 ausgebildet. Die Leiterbahnen 7 berühren einander an keiner Stelle des Thermoelements, auch nicht im Kontaktbereich 1, sie sind im Kontaktbereich 1 durch die zwischen Ihnen angeordneten Halbleiter 2, 3 voneinander getrennt.

Mit seinen Schenkeln 2, 3 ist das Thermoelement durch eine Befestigungs- und Isolationswand 4 gesteckt, so daß sich der Kontaktbereich 1 mit Abstand von der Befestigungs- und Isolationswand 4 auf deren einer Seite und die Stromabnahmestellen 5, 6 auf der anderen Seite der Befestigungs- und Isolationswand 4 befinden. Die Befestigungs- und Isolationswand 4 trennt einen Bereich erhöhter Temperatur (Heißbereich) 8 von einem Bereich niedriger Temperatur (Kaltbereich) 9. Der Kontaktbereich 1 des Thermoelements sowie die sich daran einstückig anschließenden Schenkel 2, 3 auf einem Teil ihrer Länge befinden sich im Heißbereich 8.

Neben der bekannten Draht- oder Bandtechnik kann das Thermoelement zur Gewinnung elektrischer Energie auch in Halbleitertechnik dergestalt ausgeführt werden, daß der N-leitende Halbleiterschenkel 3 im Heißbereich 8 als N-Diffusionsschicht in den P-leitenden Halbleiterschenkel 2 eingebracht ist. Die Diffusionsschicht ist ausschließlich im Heißbereich 8 ausgebildet, sie endet vor oder an der Befestigungs- und Isolationswand 4, durch die die beiden Halbleiter als getrennte Halbleiterschenkel 2, 3 zur Stromabnahme im Kaltbereich 9 hindurchgeführt sind. Es läßt sich selbstverständlich auch ein N-leitender Halbleiterschenkel mit einer P-Diffusionsschicht verwenden.

Figuren 2 und 3 zeigen Ausführungsformen des vorstehend beschriebenen Thermoelements gemäß der Erfindung. Das in Figur 2 gezeigte Thermoelement hat einen vom Heißbereich 8 zum Kaltbereich 9 durchgehenden Schenkel 2, der aus einem P-leitenden Halbleitermaterial besteht und ein erstes thermoelektrisches Material darstellt.

Als zweites thermoelektrisches Material ist eine N-Diffusionsschicht 3 in eine Außenfläche des P-Halbleiterschenkels 2 eindiffundiert. Die N-Diffusionsschicht 3 ist in der Zeichnung mit einer Strichlinie angedeutet. Die N-Diffusionsschicht 3 bedeckt den in der Heißzone 8 befindlichen Teil des P-Halbleiterschenkels 2, die N-Diffusionsschicht 3 reicht bis zur Befestigungs- und Isolationswand 4. Dieser Teil bildet den Kontaktbereich 1. Im Kaltbereich 9 ist das zweite thermoelektrische Material als N-leitender Halbleiterschenkel 13 ausgeführt, der parallel mit Abstand zum durchgehenden P-Halbleiterschenkel 2 angeordnet ist. Der P-Halbleiterschenkel 2 ist im Kaltbereich 9 auch mit der Bezugszahl 12 versehen.

Die Leiter 7 sind als auf einander abgewandte Außenseiten des durchgehenden P-Halbleiterschenkels 2 aufgesputterte Leiterbahnen 7 ausgebildet. Die auf der der N-Diffusionsschicht 3 abgewandten Außenseite aufgesputterte Leiterbahn 7 ist vom Heißbereich 8 zum Kaltbereich 9 durchgehend über die gesamte Länge des P-Halbleiterschenkels 2 ausgebildet. Die auf die N-Diffusionsschicht 3 aufgesputterte Leiterbahn 7 setzt sich durch die Befestigungs- und Isolationswand 4 hindurch auf einer dem P-Halbleiterschenkel 12 zugewandten Innenseite des N-Halbleiterschenkels 13 im Kaltbereich 9 fort. Sie weist im Kaltbereich 9 einen Abstand vom P-Halbleiterschenkel 12 auf, ist also im Kaltbereich 9 vom P-Halbleiterschenkel 12 isoliert. Es kann zusätzlich eine Isolierung zwischen dem N- und dem P-Halbleiterschenkel 13, 12 angeordnet werden. Im Kontaktbereich sind die Leiterbahnen 7 durch den zwischen ihnen befindlichten P-Halbleiterschenkel 2 mit der N-Diffusionsschicht 3 getrennt.

Aufgrund des vom Heißbereich 8 zum Kaltbereich 9 durchgehenden Schenkels 2 hat das in Figur 2 gezeigte Thermoelement eine größere Wärmeableitung. Dies kann bei der Anwendung als Fotozelle oder in einem Kfz-Auspuff von Vorteil sein. Eine elektrisch leitende Verbindung von der N-Dotierschicht 3 im Heißbereich zum separaten N-leitenden Halbleiterschenkel 13, der durch die Befestigungs- und Isolationswand 4 zum Kaltbereich führt, ist durch den von der N-Dotierschicht 3 zum N-leitenden Halbleiterschenkel 13 durchgehend ausgebildeten Leiter (Finger) 7 gewährleistet. Im Bereich der Befestigungs- und Isolationswand 4 sowie im Kaltbereich 9 sind die beiden Halbleiterschenkel 12, 13 voneinander isoliert.

Das in Figur 3 gezeigte Thermoelement ist im Kontaktbereich 1 bzw. im Heißbereich 8 als Thermoelement mit einer N-Dotierung 3 auf einem P-Wafer 2 (Träger) ausgebildet. Im Kaltbereich 9 sind zwei getrennte P- und N-leitende Halbleiterstäbe (Schenkel) 12, 13 angeordnet. Elektrische Leiterverbindungen 16 verbinden die N-Dotierung 3 mit dem N-leitenden Halbleiterschenkel 13 sowie den P-Wafer 2 mit dem P-leitenden Halbleiterschenkel 12 durch die Befestigungs- und Isolationswand 4 hindurch. Im Heiß- und im Kaltbereich sind die Leiter 7 als auf den N- und den P-Flächen aufgebrachte Leiterbahnen (Finger) ausgebildet. Bei dieser Ausgestaltung der Erfindung ist die Wärmeableitung stark reduziert und der Thermoeffekt verstärkt. Außerdem kann im Heißbereich eine Temperaturerhöhung und -speicherung durch eine nicht dargestellte Abdeckung oder Hülle aus Glas erzielt werden.

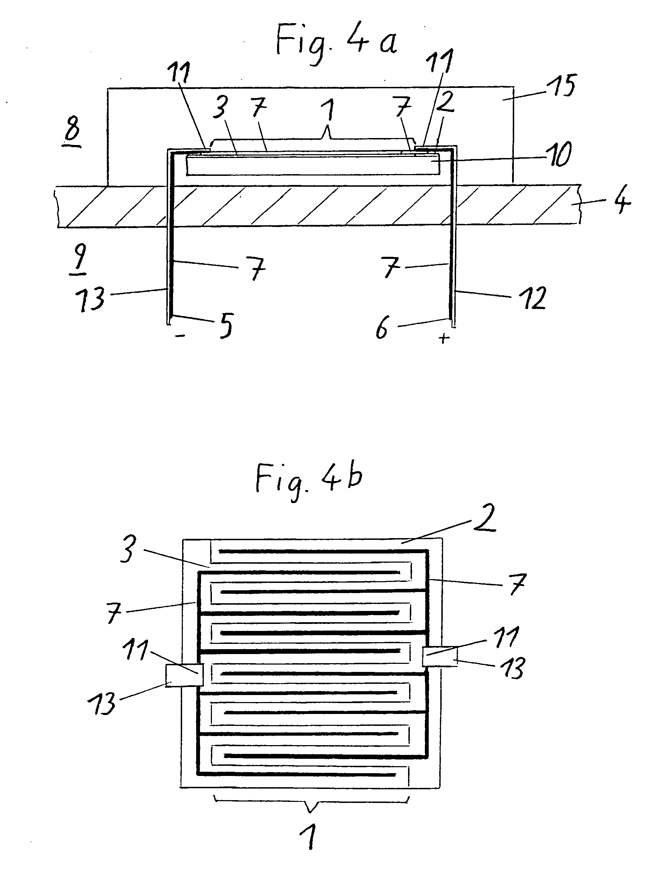

Figuren 4a und b zeigen ein erfindungsgemäßes Thermoelement mit nebeneinanderliegenden und mäanderförmig ineinander greifenden P- und N-leitenden Halbleitern 2, 3, die auf einem Wafer 10 aufgebracht sind (Figur 4b ist die Draufsicht auf Figur 4a). Auf den Halbleitern 2, 3 sind getrennt voneinander Leiterbahnen 7 aufgebracht. Diese zusätzlich und getrennt voneinander aufgebrachten Leiterbahnen 7 gehen getrennt voneinander vom Kontaktbereich 1 der beiden Halbleiter 2, 3, der einen Großteil der Fläche des Wafers 10 einnimmt, über Übergangsstellen 11 weiter über senkrecht zu einer Unterseite des Wafers 10 abgeführte P- und N-leitende Halbleiterschenkel 12, 13. Die Halbleiterschenkel 12, 13 gehen durch die Befestigungs- und Isolationswand 4 hindurch und bilden an ihren freien Ende die Stromabnahmestellen 5, 6. Durch die aufgebrachten Leiterbahnen 7 wird die elektrische Leitfähigkeit der Halbleiter 2, 3 und der Halbleiterschenkel 12, 13 verbessert. Auf der der Befestigungs- und Isolationswand 4 zugewandten Unterseite des Wafers 10 kann eine ebenso ausgebildete Kontaktflächenkonstruktion 1 aufgebracht sein, wie auf der zuvor beschriebenen Waferoberseite. Die P- und N-leitenden Halbleiterschenkel 12, 13 im Kaltbereich 9 sind Gegenstücke zu den auf den Wafer 10 aufgebrachten P- und N-leitenden Halbleiter 2, 3 im Heißbereich 8 und weisen dieselben physikalischen Eigenschaften auf. Das in Figuren 4a und b gezeigte Thermoelement ist mit einer Glashülle 15 umschlossen.

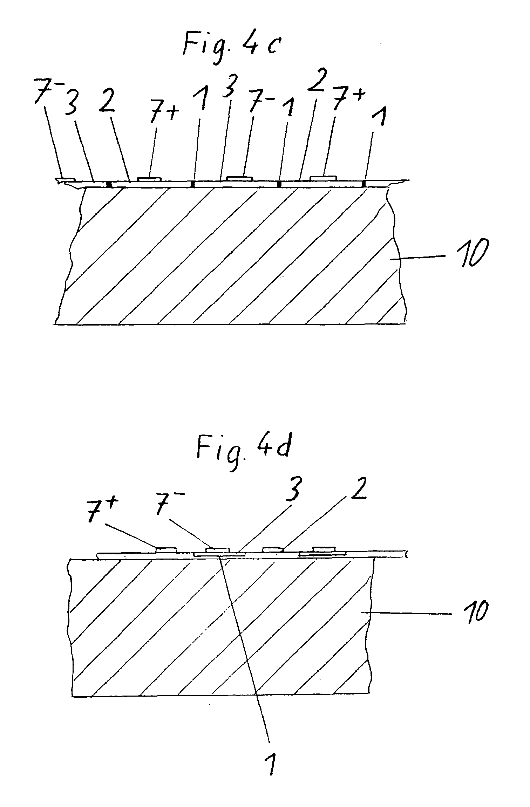

In Figuren 4c und d sind die auf den Wafer 10 aufgebrachten N- und P-leitenden Halbleiterbahnen 2, 3 sowie die auf den Halbleiterbahnen 2, 3 aufgebrachten Leiterbahnen 7 aus Figuren 4a und b im Schnitt nochmals vergrößert dargestellt. Bei der in Figur 4c gezeigten Ausgestaltung sind die Halbleiter 2, 3 als nebeneinanderliegende Bahnen ausgebildet. Bei der in Figur 4d dargestellten Ausgestaltung liegt der N-leitende Halbleiter 3 im P-leitenden Halbleiter 2 ein.

Figur 5a zeigt das Thermoelement aus Figuren 4a bis c, wobei die thermoelektrische Anordnung, wie sie in Figur 4b gezeigt ist, auf der der Befestigungs- und Isolationswand zugewandten Unterseite des Wafers 10 aufgebracht ist. Auf der Oberseite des Wafers 10 sind an sich bekannte Foto- oder Fotozellen 14 angeordnet. Es sind also erfindungsgemäße Thermoelemente mit Fotozellen kombiniert. Da die Fotozellen 14 nur einen Bruchteil der eingestrahlten Energie verbrauchen können, können zusätzlich die auf der Unterseite des Wafers 10 aufgebrachte Thermoelemente 1, 2, 3, 12, 13 mit den auf ihnen aufgebrachten Leiterbahnen 7 betrieben werden. Dies hat zusätzlich den Vorteil, daß in Extremsituationen der Wafer 10 nicht so heiß wird und der Solarbetrieb effektiver bleibt.

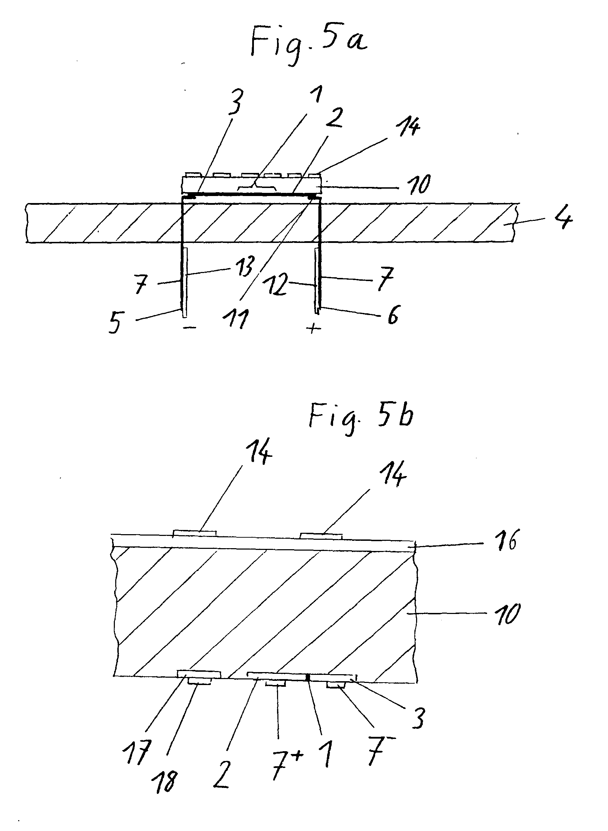

Figur 5b zeigt eine vergrößerte Schnittdarstellung des Thermoelements aus Figur 5a entsprechend Figur 4c. Das Thermoelement auf der Unterseite des Wafers 10 ist wie vorstehend zu Figuren 4a bis c beschrieben ausgebildet. Der Wafer 10 ist schwach P-dotiert. Die Fotozelle weist eine N-Dotierung 16 auf der Oberseite des Wafers 10 auf, auf der Leiterbahnen (Finger) 14 zur Ableitung des von der Fotozelle erzeugten elektrischen Stroms aufgebracht sind. Eine gegenpolige Stromableitung der Fotozelle ist auf der Waferunterseite angeordnet. Sie ist als starke P-Dotierung 17 ausgebildet, auf der eine Leiterbahn (Finger) 18 aufgebracht ist.

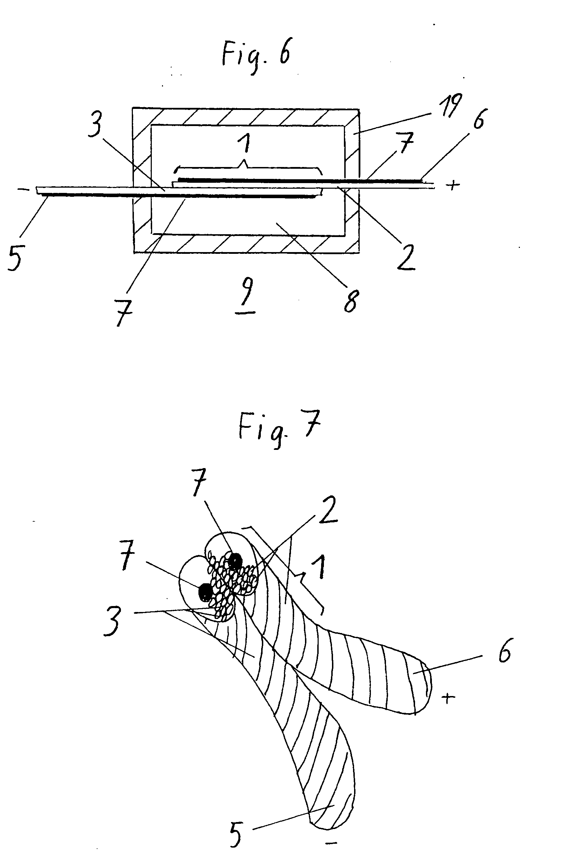

Figur 6 zeigt eine Ausgestaltung der Erfindung zur Anwendung in einem Rechteckrohr 19, beispielsweise einem Kraftwagenauspuff oder einem Kamin.

Das Innere des Rechteckrohrs 19 bildet den Heißbereich 8, die Außenseite ist der Kaltbereich 9. Das im Rechteckrohr 19 angeordnete Thermoelement weist einen P- und einen N-leitenden Halbleiterschenkel 2, 3 als thermoelektrische Materialien auf, die innerhalb des Rechteckrohrs 19 einander überlappen und zu verschiedenen Seiten getrennt voneinander aus dem Rechteckrohr 19 herausgeführt sind. Im Überlappungsbereich, der den Kontaktbereich 1 des Thermoelements bildet, stehen die beiden Halbleiterschenkel 2, 3 in Kontakt miteinander. Leiterbahnen 7 sind, wie zu Figur 1 beschrieben, auf einander abgwandten Außenseiten der Halbleiterschenkel 2, 3 über die gesamte Länge des jeweiligen Halbleiterschenkels 2, 3 durchgehend aufgebracht bis zu äußeren Enden der Halbleiterschenkel 2, 3, die Stromabnahmestellen 5, 6 bilden. Die Leiterbahnen 7 sind durch die zwischen ihnen angeordneten Halbleiterschenkel 2, 3 voneinander getrennt.

Figur 7 zeigt ein erfindungsgemässes Thermoelement mit zwei Drahtbündeln aus verdrillten Einzeldrähten. Die Einzeldrähte 2 des einen Drahtbündels bestehen aus einem P-leitenden Halbleiter als thermoelektrischem Material, die Einzeldrähte 3 des anderen Drahtbündels bestehen aus einem N-leitenden Halbleiter als thermoelektrischem Material. In der Mitte beider Drahtbündel liegt ein Silberdraht 7 als Leiter ein, der eine Seele des jeweiligen Drahtbündels bildet und um den herum die Einzeldrähte 2, 3 gedrillt sind. Zur Ausbildung des Kontaktbereichs 1 des Thermoelements sind die beiden Drahtbündel an einem Ende über einen Teil ihrer Länge mit ihrem Umfang aneinder gepreßt, so daß die Halbleiter-Einzeldrähte 2, 3 in Kontakt miteinander sind. Die Silberdrähte 7 der beiden Drahtbündel sind durch die sie umgebenden Halbleiter-Einzeldrähte 2, 3 voneinander getrennt. Außerhalb des Kontaktbereichs 1 sind die Drahtbündel voneinander getrennt, ihre dem Kontaktbereich 1 fernen Enden bilden Stromabnahmestellen 5, 6.

Bei sämtlichen Ausgestaltungen ist zu beachten, daß die Leiter bzw. Leiterbahnen 7 nirgends, auch nicht im Kontaktbereich 1, durch einen Kurzschluß elektrisch leitend miteinander verbunden sind, da in diesem Fall der Thermoeffekt verloren ginge. Die Schenkel 2, 3, 12, 13 sind außerhalb des Kontaktbereichs 1 einwandfrei getrennt voneinander und es besteht lediglich im Kontaktbereich 1 in der Heißzone 8 der insbesondere thermische Kontakt der thermoelektrischen Materialien (P- und N-leitendende Halbleiter) 2,3. Wie in Figur 4b gezeigt, können mehrere, gleich gepolte Leiter 7 auf dem Wafer 10 zusammengefaßt und gemeinsam zu den P- sowie den N-Halbleiterschenkeln 12, 13 im Kaltbereich geführt werden. Bei der elektrischen Hintereinanderschaltung von mehreren erfindungsgemäßen Thermoelementen werden der P-leitenden Halbleiterschenkel eines Thermoelements mit dem N-leitenden Halbleiterschenkel eines weiteren Thermoelements im Kaltbereich elektrisch leitend miteinander verbunden.

Anstelle der in den Ausführungsbeispielen beschriebenen Halbleiter 2, 3 können ebenso Nichtleiter/elektrische Widerstandsmaterialien mit hohem Seebeck-Koeffizienten als thermoelektrische Materialien Verwendung finden.

## Patentansprüche

1. Thermoelement zur Gewinnung elektrischer Energie, mit zwei verschiedenen thermoelektrischen Materialien (2, 3), die in einem Kontaktbereich (1) elektrisch leitend miteinander verbunden sind, **dadurch gekennzeichnet, dass** die beiden thermoelektrischen Materialien (2, 3) außerhalb des Kontaktbereichs (1) als elektrisch voneinander isolierte Schenkel (2, 3) ausgebildet sind, und dass jedes der beiden thermoelektrischen Materialien (2, 3) einen elektrisch gut leitenden Leiter (7) mit einer elektrischen Leitfähigkeit in der Größenordnung einer Silberlegierung aufweist, wobei die Leiter (7) sowohl im Kontaktbereich (1) als auch im Bereich der Schenkel (2, 3) ausgebildet und im wesentlichen über ihre gesamte Länge elektrisch leitend mit dem jeweiligen thermoelektrischen Material (2, 3) verbunden sind, jedoch an keiner Stelle Kontakt miteinander aufweisen.

2. Thermoelement nach Anspruch 1, **dadurch gekennzeichnet, daß** die Leiter (7) thermisch neutral sind.

3. Thermoelement nach Anspruch 1 oder 2, **dadurch gekennzeichnet, daß** das Thermoelement einen großen Kontaktbereich (1) aufweist, der die beiden thermoelektrischen Materialien (2, 3) innerhalb eines Bereichs erhöhter Temperatur (Heißbereich) (8) zumindest nahezu vollständig umfaßt.

4. Thermoelement nach einem der Ansprüche 1 bis 3, **dadurch gekennzeichnet, daß** der beiden verschiedenen thermoelektrischen Materialien (2, 3) als Drahtbündel ausgebildet ist, in welchem ein Draht als elektrischer Leiter (7) einliegt, wobei die thermoelektrischen Materialien (2, 3) der beiden Drahtbündel im Kontaktbereich (1) elektrisch leitend miteinander in Kontakt sind, wogegen die die elektrischen Leiter (7) bildenden Drähten voneinander getrennt sind.

5. Thermoelement nach einem der Ansprüche 1 bis 4, **dadurch gekennzeichnet, daß** die thermoelektrischen Materialien (2, 3, 12, 13) in dem Bereich erhöhter Temperatur (Heißbereich) (8) sowie in einem Bereich niedriger Temperatur (Kaltbereich) (9) ausgebildet sind, daß die thermoelektrischen Materialien (2, 3, 12, 13) in einem Übergangsbereich vom Heißbereich (8) zum Kaltbereich (9) unterbrochen sind, und daß die Leiter (7) der thermoelektrischen Materialien (2, 3, 12, 13) für jedes thermoelektrische Material (2, 3, 12, 13) getrennt durch je einen zusätzlichen Leiter (16) elektrisch leitend miteinander verbunden sind.

6. Thermoelement nach einem der vorhergehenden Ansprüche, **dadurch gekennzeichnet, daß** ein thermischer Isolationsbereich (4) im Übergangsbereich vom Heißbereich (8) zum Kaltbereich (9) als Wärmespeicher ausgebildet ist, und daß die beiden thermoelektrischen Materialien (2, 3) im Heißbereich (8) eine wärmespeichernde Abdeckung (15) aufweisen.

7. Thermoelement nach einem der vorhergehenden Ansprüche, **dadurch gekennzeichnet, daß** das Thermoelement auf einer Seite eines Trägers (Wafer) (10) angeordnet ist, und daß auf der anderen Seite des Trägers (10) ein Fotoelement (14) angeordnet ist.

8. Thermoelement nach Anspruch 7, **dadurch gekennzeichnet, daß** das Fotoelement (14) zwei verschiedene thermoelektrische Materialien (2, 3) aufweist, die in einem Kontaktbereich (1) elektrisch leitend miteinander verbunden sind, daß die beiden thermoelektrischen Materialien (2, 3) außerhalb des Kontaktbereichs (1) als elektrisch voneinander isolierte Schenkel (2, 3) ausgebildet sind, und daß jedes der beiden thermoelektrischen Materialien (2, 3) einen elektrisch gut leitenden Leiter (7) aufweist, wobei die Leiter (7) sowohl im Kontaktbereich (1) als auch im Bereich der Schenkel (2, 3) ausgebildet und im wesentlichen über ihre gesamte Länge elektrisch leitend mit dem jeweiligen thermoelektrischen Material (2, 3) verbunden sind, jedoch an keiner Stelle Kontakt miteinander aufweisen.

9. Thermoelement nach einem der vorhergehenden Ansprüche, **dadurch gekennzeichnet, daß** es als Seebeck-Kühlelement ausgebildet ist.

## Claims

1. Thermocouple device for obtaining electric energy, said device having two different thermoelectric materials (2, 3), which are interconnected in an electrically conductive manner in a contact region (1), **characterised in that** the two thermoelectric materials (2, 3) externally of the contact region (1) are in the form of portions (2, 3) which are electrically insulated from each other, and **in that** each of the two thermoelectric materials (2, 3) has a good electrically conductive conductor (7) with an electric conductivity in the order of magnitude of a silver alloy, the conductors (7) being provided both in the contact region (1) and in the region of the portions (2, 3) and being connected in an electrically conductive manner substantially to the respective thermoelectric material (2, 3) over their entire length, yet having no contact with each other at any point.

2. Thermocouple device according to claim 1, **characterised in that** the conductors (7) are thermally neutral.

3. Thermocouple device according to claim 1 or 2, **characterised in that** the thermocouple device has a large contact region (1), which includes, at least virtually completely, the two thermoelectric materials (2, 3) internally of a region of high temperature (hot region) (8).

4. Thermocouple device according to one of claims 1 to 3, **characterised in that** one of the two different thermoelectric materials (2, 3) is in the form of a wire bundle, in which one wire serves as the electric conductor (7), the thermoelectric materials (2, 3) of the two wire bundles being in contact each other in the contact region (1) in an electrically conductive manner, whereas the wires forming the electric conductors (7) are separated from each other.

5. Thermocouple device according to one of claims 1 to 4, **characterised in that** the thermoelectric materials (2, 3, 12, 13) are provided in the region of high temperature (hot region) (8) as well as in a region of low temperature (cold region) (9), **in that** the thermoelectric materials (2, 3, 12, 13) are interrupted in a transitional region from the hot region (8) to the cold region (9), and **in that** the conductors (7) of the thermoelectric materials (2, 3, 12, 13) are interconnected in an electrically conductive manner by a respective additional conductor (16), separately for each thermoelectric material (2, 3, 12, 13).

6. Thermocouple device according to one of the preceding claims, **characterised in that** a thermal insulation region (4) is in the form of a heat retainer in the transitional region from the hot region (8) to the cold region (9), and **in that** the two thermoelectric materials (2, 3) have a heat-retaining covering (15) in the hot region (8).

7. Thermocouple device according to one of the preceding claims, **characterised in that** the thermocouple device is disposed on one side of a carrier (wafer) (10), and **in that** a photoelectric element (14) is disposed on the other side of the carrier (10).

8. Thermocouple device according to claim 7, **characterised in that** the photoelectric element (14) has two different thermoelectric materials (2, 3), which are interconnected in an electrically conductive manner in a contact region (1), **in that** the two thermoelectric materials (2, 3) externally of the contact region (1) are in the form of portions (2, 3) which are electrically insulated from each other, and **in that** each of the two thermoelectric materials (2, 3) has a good electrically conductive conductor (7), the conductors (7) being provided both in the contact region (1) and in the region of the portions (2, 3) and being connected in an electrically conductive manner substantially to the respective thermoelectric material (2, 3) over their entire length, yet having no contact with each other at any point.

9. Thermocouple device according to one of the preceding claims, **characterised in that** it is in the form of a Seebeck cooling element.

## Revendications

1. Thermocouple permettant d'obtenir de l'énergie électrique, avec deux matériaux thermoélectriques (2, 3) différents reliés ensemble de manière électroconductrice dans une zone de contact (1), **caractérisé par le fait que** les deux matériaux thermoélectriques (2, 3) se présentent en dehors de la zone de contact (1) sous la forme de branches (2, 3) électriquement isolées l'une de l'autre et que chacun des deux matériaux thermoélectriques (2, 3) présente un conducteur (7) bon conducteur de l'électricité, ayant une conductibilité électrique de l'ordre de celle d'un alliage d'argent, les conducteurs (7) étant formés aussi bien dans la zone de contact (1) que dans la zone des branches (2, 3) et reliés de manière électroconductrice, essentiellement sur toute leur longueur, avec le matériau thermoélectrique (2, 3) respectif, mais ne présentant en aucun point de contact entre eux.

2. Thermocouple selon la revendication 1, **caractérisé par le fait que** les conducteurs (7) sont thermiquement neutres.

3. Thermocouple selon la revendication 1 ou 2, **caractérisé par le fait que** le thermocouple présente une grande zone de contact (1) qui englobe les deux matériaux thermoélectriques (2, 3) au moins presque complètement à l'intérieur d'une zone de température élevée (zone chaude) (8).

4. Thermocouple selon l'une des revendications 1 à 3, **caractérisé par le fait que** les deux matériaux thermoélectriques (2, 3) différents sont réalisés sous forme de faisceaux de fils dans lequel un fil est inclus en tant que conducteur électrique (7), les matériaux thermoélectriques (2, 3) des deux faisceaux de fils étant en contact électroconducteur dans la zone de contact (1) tandis que les fils formant les conducteurs électriques (7) sont séparés l'un de l'autre.

5. Thermocouple selon l'une des revendications 1 à 4, **caractérisé par le fait que** les matériaux thermoélectriques (2, 3, 12, 13) sont formés dans la zone de température élevée (zone chaude) (8) ainsi que dans une zone de basse température (zone froide) (9), que les matériaux thermoélectriques (2, 3, 12, 13) sont interrompus dans une zone de transition de la zone chaude (8) à la zone froide (9) et que les conducteurs (7) des matériaux thermoélectriques (2, 3, 12, 13) sont reliés ensemble de manière électroconductrice, séparément pour chaque matériau thermoélectrique (2, 3, 12, 13), par un conducteur (16) supplémentaire.

6. Thermocouple selon l'une des revendications précédentes, **caractérisé par le fait qu'**une zone d'isolation thermique (4) dans la zone de transition de la zone chaude (8) à la zone froide (9) est réalisée sous forme d'accumulateur de chaleur et que les deux matériaux thermoélectriques (2, 3) présentent dans la zone chaude (8) un recouvrement (15) qui emmagasine la chaleur.

7. Thermocouple selon l'une des revendications précédentes, **caractérisé par le fait que** le thermocouple est disposé sur un côté d'un support (galette) (10) et qu'un élément photoélectrique (14) est disposé de l'autre côté du support (10).

8. Thermocouple selon la revendication 7, **caractérisé par le fait que** l'élément photoélectrique (14) présente deux matériaux thermoélectriques (2, 3) différents qui sont reliés ensemble de manière électroconductrice dans une zone de contact (1), que les deux matériaux thermoélectriques (2, 3) se présentent en dehors de la zone de contact (1) sous la forme de branches (2, 3) électriquement isolées l'une de l'autre et que chacun des deux matériaux thermoélectriques (2, 3) présente un conducteur (7) bon conducteur de l'électricité, les conducteurs (7) étant formés aussi bien dans la zone de contact (1) que dans la zone des branches (2, 3) et reliés de manière électroconductrice, essentiellement sur toute leur longueur, avec le matériau thermoélectrique (2, 3) respectif, mais ne présentant en aucun point de contact entre eux.

9. Thermocouple selon l'une des revendications précédentes, **caractérisé par le fait qu'**il est réalisé sous forme d'élément de refroidissement par effet Seebeck.
